# EUROPEAN PATENT SPECIFICATION

(11) **EP 1 257 159 B1**
(45) Date of publication and mention of the grant of the patent: **10.01.2007**
(21) Application number: 01830297.6
(22) Date of filing: 09.05.2001
(51) Int. Cl.: H05K 5/02, G08B 13/08

(54) **Frame resisting breaking, tampering or removing attempts, particularly for alarm devices**
Rahmen welcher gewaltsamen Eingriffen, Manipulation oder Entfernung widersteht, insbesondere für Alarmanlagen
Cadre de support résistant à la rupture, à l'accès non autorisé ou à des tentatives d'enlèvement, en particulier pour des systèmes d'alarme

(43) Date of publication of application: 13.11.2002
(73) Proprietor: Schneider, Luigi, 00047 Marino (Roma) (IT)
(72) Inventor: Schneider, Luigi, 00047 Marino (Roma) (IT)
(74) Representative: Sarpi, Maurizio

(56) References cited:
- DE-A- 3 420 439
- US-A- 4 649 376

## Description

The present invention relates to a support frame or container, particularly for supporting acoustic and visual alarm devices, which is adapted to resist against breaking, tampering and removing attempts.

Several kinds of acoustic alarm systems, frequently provided with lightening lamps, are known, which are grounded on different systems for detecting breaking and tampering attempts of thieves or non authorized persons and have a container or support frame for acoustic or lightening alarm devices.

Usually, such containers or frames are arranged on an outer wall of the building to be protected, for both the audibility and visibility of a possible tampering attempt.

However, the problem of such alarm systems consists in that their outer support frames may be easily neutralized by removing them from the building wall by means of a lever like tools, which eradicate expansion dowels, generally used for anchoring the support container on the building wall, and by cutting the wires connecting them with the central alarm plant.

An object of the present invention is that to provide a container or support frame of the above said kind, which is capable to resist tampering and/or neutralizing attempts of thieves or not authorized people.

This aim is achieved by a system for anchoring said support frame on the outer surface of a building wall, which hinders any tampering attempt or at least renders it very arduous and difficult, bearing in mind that such attempts must be performed quickly and silently for avoiding to be spotted.

The support frame according to the present invention consists of a pyramid shaped container to be secured on the outer surface of a building wall.

The container has a base to be applied onto the outer face of the building wall, which base may have any shape or configuration, e.g. a polygonal form, such as triangular, rectangular, pentagonal, hexagonal or like shape.

A further object of the present invention is to provide means which could allow to assume the parallelism of holes to be bored in a building wall for firmly anchoring the support container thereon.

Such means consists of a counter plate having an arrangement of openings which is an exact reproduction of that provided on the container base, around each of said openings a sleeve like tubular projection being provided, which once introduced in corresponding holes to be drilled in the building wall, acts as a guide for a hand drill used for boring the wall, thus assuring both an exactly parallel extension of the holes bored in the building wall and a greater resistance to the removal attempt obtained by the abutment of the tubular sleeve onto step between the short hole and through hole.

Summarizing, a general object of the present invention is that to provide a support frame apt to resist breaking, tampering and removing attempts, particularly for supporting acoustic and visual alarm devices, anchored onto an outer wall of a building and having a polygonal, preferably triangular pyramidal shape, wherein the lower edges of the support frame are inwardly folded to form strips to be applied to the building outer wall, openings being provided at the both ends of each support strip, a counter plate being provided, which has openings, each corresponding to at least one of the two openings of each strip and a tubular sleeve rigidly fixed to said plate around each opening and projecting towards the inner face of the building wall, said sleeves being introduced into corresponding holes drilled in said inner face and having the length of said tubular sleeves, through holes being drilled in said building wall through said tubular sleeves, assuring thus an exact parallelism of the through holes, the outer ends thereof coming out exactly in front of the corresponding openings of the strips, screw bolts being introduced through the tubular sleeves into the through holes and nuts being fastened onto the inner and outer ends of the screw bolts.

Said aims have been obtained by a support frame according to claim 1.

The invention will be now disclosed with reference to an embodiment thereof as shown in the enclosed drawings, in which:
Fig. 1 shows a perspective view of a support frame for an alarm system arranged therein, having triangular pyramid shape;
Fig. 2 is a perspective view of the same support frame as seen from a lower side, having an acoustic and visual alarm device arranged therein;
Fig. 3 shows the container arranged with his triangular base in front of a triangular counter-plate;
Figs. 4 to 6 illustrate how the triangular counter-plate is to be placed on the screw wall of building wall;
Fig. 7 shows another manner of anchoring the container on the outer face of a building wall by means of screw bolts, nuts and washers without the counter-plate;
Fig. 8 shows a bolt and a counter-bolt forming an adjustment unit for placing the container on the outer face of a building wall, and
Fig. 9 shows the container with the adjustment unit of Fig. 8.

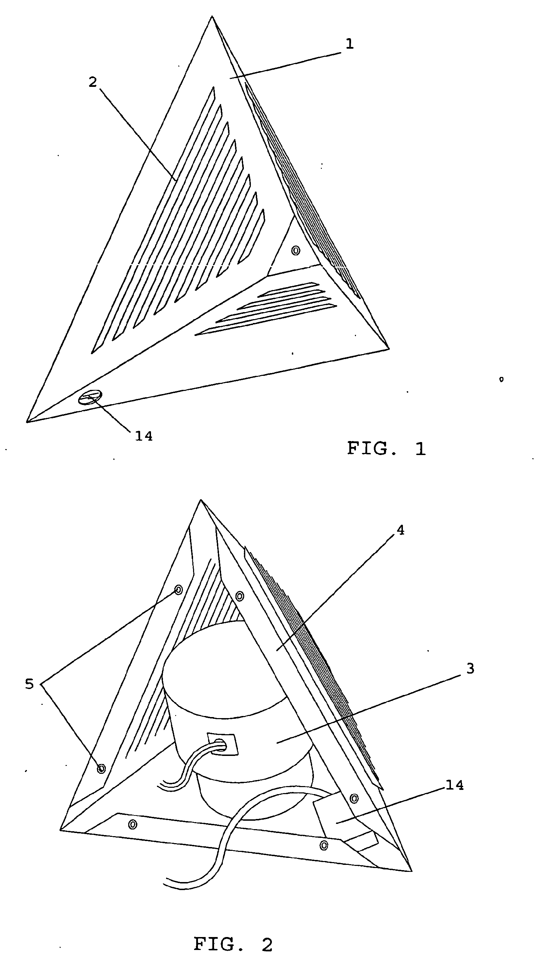

Referring now to Fig. 1 of the drawings, a container or support frame 1 for the alarm system according to the present invention has preferably a triangular pyramid shape with several slots 2 on its all free faces, which slots are preferably parallel to the sides of the triangular base of the pyramid.

Each of said slots 2 has stretching-out cutting edges suitable to injure the thieves or unauthorized people that attempt to tamper the device.

As it may be seen in Fig. 2 within the container an acoustic and lightening (visual) device 3 is arranged and at the ends of each side 4 of the triangular container ba-se an opening 5 is provided, such holes being used for anchoring the container on the outer face of a building wall.

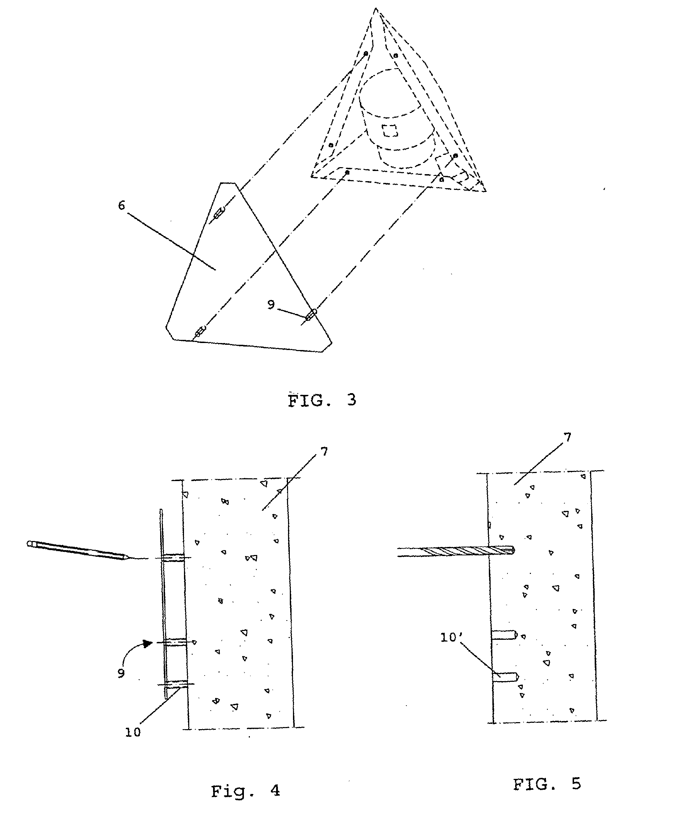

Fig. 3 to 6 show how a counter-plate 6 may be used for performing holes 8 through a building wall 7. The counter plate 6 has shape, substantially corresponding to the shape of the triangular pyramid base and, in this case, three holes 9 corresponding to the respective three holes 5 on the three sides 4 of the container base.

An important problem bound with the operation of anchoring the container on the outer face of a building wall is that of maintaining the parallelism of the holes bored in the wall, since even a small deviation from the parallel extension thereof would render necessary a repetition of the boring operation with all the drawbacks caused thereby, such as closure (cementation) of the erroneous holes, lost of time etc.

For avoiding this drawback, the counter-plate 6 according with the present invention is provided with , in this case three, circular openings 9 surrounded each by a tubular sleeve 10, projecting towards the inner wall of the building.

The operator carrying-out the operation of anchoring the support container onto the outer building wall, applies the counter-plate to the inner wall, signs thereon with a pencil, pen or like, introduced through said tubular sleeve 10, the points at which the holes should be bored through the building wall so as to come out from the outer wall exactly in correspondence with the anchoring openings of the container to be secured on the building.

After having signed said points, the operator bores in the wall the holes 10' having the length of the tubular sleeves 10. After having bored such holes, he applies the counter plate to the inner face of the wall by introducing the tubular sleeves 10 into the corresponding holes 10'. Now, the operator introduces the tool of a hand drill into said sleeves and bores, successively, the through holes 8 in said wall 7. The holes 8 are exactly parallel to one another, since the sleeves 10 act as guides and do not allow any deviation of the drill. The length of the tubular sleeves 10 depending preferably on the thickness of the wall 7 to be pierced, and corresponding generally to 15-30% of the wall thickness (said percentage it is not mandatory).

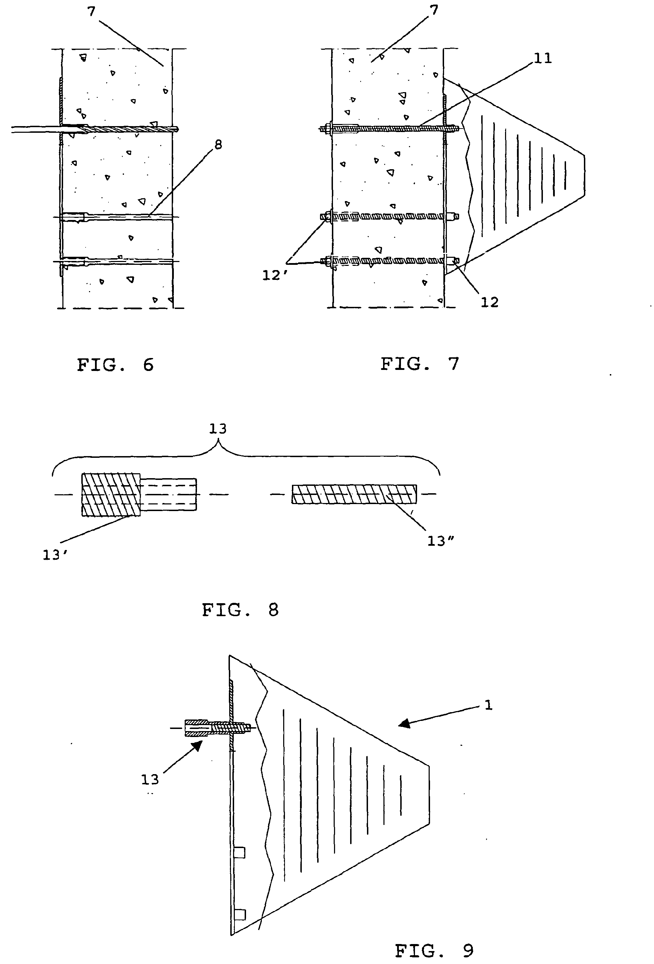

After having performed the boring operation, screw bolts 11 are introduced into the holes 8 bored in the building wall and then throughout the openings 5 of the container base and screwed into inner projections 12 rigidly connected with said base around the openings 5, of the container, said projections 12 being innerly threaded to receive the outer end of the screw bolts 11 (Fig. 7).

Once introduced the screw bolts 11 into the holes bored in the building wall, the counter-plate 6 may be removed and the inner end of the screw bolts may be secured to the inner face of the wall either by suitably sized round washers and nuts or by the counter plate itself, likely fixed by nuts 12'.

The present invention provides also a plurality of adjustment tubular elements respectively consisting of two parts 13' and 13", the part 13" being screwed into one of said inner threaded projections 12 of the container base and the part 13' being introduced at its own thicker end into a widening of the through hole 8 on outer face of the building wall and being screwed on the part 13" projecting from the projection 12. In this way by adjusting the screwing length of the part 13" within the threaded inner hole of the part 13' it will be possible to compensate the possible disuniformities of the outer surface of the building wall, the thicker portion of the parts 13' being screwed on the outer end of the screw bolts 11.

In order to increase the effectiveness of the alarm device in the prevention of the tampering and/or breaking attempts, the invention is also equipped with detection means 14 suitable to watch the movements in proximity of the structure of support or container 1.

In the illustrated example, said mans comprise a sensor of proximity 14 preferably placed on the side of container 1 that is faced to the direction more easy accessible by thieves or not authorized people.

Such sensor 14 is suitable to activate the alarm signal before the thieve can touch the container 1 itself.

The present invention has been disclosed with reference to a preferred embodiment thereof, but several changes and modifications may be performed by those skilled in the art within the scope of the claims.

## Claims

1. A support frame or container apt to resist breaking, tampering and removing attempts, particularly for supporting acoustic and visual alarm devices, to be anchored onto an outer wall of a building and having a polygonal, preferably triangular pyramidal shape, wherein the lower edges of the support frame (1) are inwardly folded to form strips (4) to be applied to the building outer wall, openings (5) being provided at the both ends of each support strip (4), a counter plate (6) being provided, which has openings (9), each corresponding to at least one of the two openings (5) of each strip (4) and a tubular sleeve (10) rigidly fixed to said plate (6) round each opening (9) and in use projecting towards the inner face of the building wall, said sleeves (10) in use being introduced into corresponding holes (10') drilled in an inner face of a wall and having the length of said tubular sleeves (10), further in use through holes (8) being drilled in said building wall, screw bolts (11) for being introduced through the tubular sleeves (10) into the through holes (8) and nuts (12, 12') for being fastened onto the inner and outer ends of the screw bolts (11).

2. A support frame or container as claimed in claim 1, wherein an adjusting element (13) is provided, which consists of a first part (13') having a threaded inner hole screwed onto the outer end of the screw bolt (11), and of a second part (13") screwed into said inner hole of said first part (13') and passing through the respective opening (5) of said strip (4), said adjusting element (13) adjusting the correct position of the support frame (1) by compensating possible disuniformities of the outer face of the building wall.

3. A support frame or container as claimed in claim 1, wherein said counter plate is removed after having drilled said through holes (8) in the building walls, parallel to one another, and replaced by washers fastened by nuts (12') to the outer face of the building wall.

4. A support frame or container as claimed in claim 1, wherein several slots (2) are provided on its all free faces, which slots are preferably parallel to the sides of the triangular base of the pyramid.

5. A support frame or container as claimed in claim 4, wherein each of said slots (2) has a stretching-out cutting edge suitable to injure the thieves or unauthorized people that attempt to tamper the device.

6. A support frame or container as claimed in claim 1, wherein it is provided detection means (14) of the movements in proximity of the structure of support or container (1).

7. A support frame or container as claimed in claim 6, wherein said detecting means comprises a known sensor of proximity (14) preferably placed on the side of container (1) that is faced in the direction more easily accessible by thieves or not authorized people; such sensor (14) being suitable to activate the alarm signal before the thieves can touch the container (1) itself.

## Patentansprüche

1. Trägerrahmen oder Behälter, angepasst um Einbruchs-, Manipulations- und Entfernungsversuchen zu widerstehen, insbesondere zur Aufnahme akustischer und visueller Alarmeinrichtungen, welcher an eine Außenwand eines Gebäudes befestigbar ist und eine vieleckige, bevorzugt dreieckige Pyramidenform aufweist, wobei die unteren Kanten des Trägerrahmens (1) nach innen geklappt sind, um Anschlussleisten (4) zu bilden, welche an der Außenwand des Gebäudes anbringbar sind, wobei Öffnungen (5) an beiden Enden jeder Anschlussleiste vorgesehen sind, wobei eine Gegenplatte (6) vorgesehen ist, die Öffnungen (9) aufweist, von denen jede mit zumindest einer der zwei Öffnungen (5) jeder Anschlussleiste (4) übereinstimmt und wobei jeweils eine rohrförmige Hülse (10) starr an der Platte (6) um jede Öffnung (9) angebracht ist und bei Anbringung in Richtung der inneren Seite der Gebäudewand ragt, wobei die Hülsen (10) bei Anbringung in zugeordnete Löcher (10') einführbar sind, die in die innere Seite einer Wand gebohrt sind und die Länge der rohrförmigen Hülsen besitzen, wobei ferner bei Anbringung Durchgangslöcher (8) in die Gebäudewand gebohrt sind, Gewindebolzen (11) durch die rohrförmigen Hülsen (10) in die Durchgangslöcher (8) eingeführt und Muttern (12,12') auf den inneren und äußeren Enden der Gewindebolzen befestigt sind.

2. Trägerrahmen oder Behälter nach Anspruch 1, wobei ein Einstellelement (13) vorgesehen ist, welches aus einem ersten Teil (13'), das ein inneres Gewindeloch aufweist und auf das äußere Ende des Gewindebolzens (11) schraubbar ist, und aus einem zweiten Teil (13'') besteht, welches in das innere Loch des ersten Teils (13') schraubbar ist und die zugeordnete Öffnung (5) der Anschlussleite durchquert, wobei das Einstellelement (13) die richtige Position des Trägerrahmens (1) durch Ausgleichen von etwaigen Unregelmäßigkeiten der äußeren Seite der Gebäudewand einstellt.

3. Trägerrahmen oder Behälter nach Anspruch 1, wobei die Gegenplatte (6) nach dem Bohren der zueinander parallelen Durchgangslöcher(8)in die Gebäudewand entfernbar ist und durch Scheiben ersetzbar ist, die durch Muttern (12') an die äußere Seite der Gebäudewand befestigbar ist.

4. Trägerrahmen oder Behälter nach Anspruch 1, wobei mehrere Schlitze (2) an allen freiliegenden Flächen vorgesehen sind, wobei die Schlitze bevorzugt parallel zu den Seiten der dreieckigen Grundfläche der Pyramide sind.

5. Trägerrahmen oder Behälter nach Anspruch 4, wobei jeder der Schlitze (2) eine vorstehende Schneidekante aufweist, die dazu geeignet ist Diebe oder unautorisierte Personen, die versuchen die Vorrichtung zu manipulieren, zu verletzen.

6. Trägerrahmen oder Behälter nach Anspruch 1, wobei Mittel (14) zur Erkennung von Bewegungen in der Nähe der Anordnung des Trägerrahmens oder des Behälters vorgesehen sind.

7. Trägerrahmen oder Behälter nach Anspruch 6, wobei die Erkennungsmittel einen Näherungssensor (14) bekannter Art aufweisen, welcher bevorzugt an der Seite des Behälters (1) angeordnet ist, die in die Richtung weist, die einfacher für die Diebe oder umautorisierte Personen zugänglich ist; und wobei solch ein Sensor (14)geeignet ist, das Alarmsignal zu aktivieren, bevor die Diebe den Behälter (1) an sich berühren können.

## Revendications

1. Cadre de support ou coffret apte à résister à la rupture, à l'accès non autorisé et à des tentatives d'enlèvement, pour supporter en particulier des dispositifs d'alarme acoustique et visuelle, destiné à être ancré sur un mur extérieur d'un bâtiment et ayant une forme de polygone, en pyramide triangulaire de préférence, dans lequel les bords inférieurs du cadre de support (1) sont repliés vers l'intérieur de manière à former des bandes (4) destinées à être appliquées sur le mur extérieur du bâtiment, des ouvertures (5) étant prévues au niveau des deux extrémités de chaque bande (4), une plaque d'appui arrière (6) étant prévue, qui comporte des ouvertures (9) qui correspondent chacune à au moins une des deux ouvertures (5) de chaque bande (4), et un manchon tubulaire (10) qui est fixé de façon rigide à ladite plaque (6) autour de chaque ouverture (9) et qui - pour l'utilisation - fait saillie en direction de la face interne du mur du bâtiment, lesdits manchons (10) étant introduits - pour l'utilisation - dans des trous correspondants (10') percés dans la face interne d'un mur et ayant la longueur desdits manchons tubulaires (10), d'autres trous de passage (8) étant percés - pour l'utilisation - dans ledit mur du bâtiment, et des boulons (11) destinés à être introduits à travers les manchons tubulaires (10) à l'intérieur des trous de passage (8) et des écrous (12, 12') destinés à être montés sur les extrémités intérieure et extérieure des boulons (11).

2. Cadre de support ou coffret selon la revendication 1, dans lequel un élément de réglage (13) est prévu, qui comprend une première partie (13') munie d'un trou interne taraudé vissé sur l'extrémité extérieure du boulon (11), et d'une deuxième partie (13") vissée à l'intérieur dudit trou interne de ladite première partie (13') et qui passe à travers l'ouverture respective (5) de ladite bande (4), ledit élément de réglage (13) ayant pour fonction de régler la position correcte du cadre de support (1) en compensant tout défaut d'uniformité possible de la face extérieure du mur du bâtiment.

3. Cadre de support ou coffret selon la revendication 1, dans lequel ladite plaque d'appui arrière est retirée après que lesdits trous de passage (8) ont été percés dans les murs du bâtiment, parallèlement les uns aux autres, et remplacée par des rondelles retenues par des écrous (12') sur la face extérieure du mur du bâtiment.

4. Cadre de support ou coffret selon la revendication 1, dans lequel plusieurs fentes (2) sont prévues sur toutes ses faces libres, ces fentes étant de préférence parallèles aux côtés de la base triangulaire de la pyramide.

5. Cadre de support ou coffret selon la revendication 4, dans lequel chacune desdites fentes (2) possède un bord de coupe en prolongement, qui est prévu pour blesser les voleurs ou toute personne non autorisée qui tenterait d'accéder au dispositif de façon malveillante.

6. Cadre de support ou coffret selon la revendication 1, dans lequel des moyens de détection (14) de mouvements à proximité de la structure de support ou du coffret (1) sont prévus.

7. Cadre de support ou coffret selon la revendication 6, dans lequel lesdits moyens de détection comprennent un détecteur de proximité (14) d'un type connu, qui est placé sur le côté du coffret (1) de préférence, et qui est dirigé dans la direction la plus facilement accessible par des voleurs ou des personnes non autorisées ; ce détecteur (14) ayant la particularité d'activer le signal d'alarme avant que les voleurs ne puissent toucher le coffret (1) lui-même.
